Europäisches Patentamt

European Patent Office

Office européen des brevets

(11) Veröffentlichungsnummer: **0 429 910 A1**

# (12) EUROPÄISCHE PATENTANMELDUNG

(21) Anmeldenummer: 90121369.4

(22) Anmeldetag: 08.11.90

(51) Int. Cl.5: **H01Q 1/50, H02G 13/00**

(30) Priorität: 17.11.89 DE 3938236

(43) Veröffentlichungstag der Anmeldung:
05.06.91 Patentblatt 91/23

(84) Benannte Vertragsstaaten:
AT CH DE FR GB LI Patentblatt 1

(71) Anmelder: TELEFUNKEN SYSTEMTECHNIK GMBH
Sedanstrasse 10
W-7900 Ulm (Donau)(DE)

(72) Erfinder: Nedtwig, Joachim, Dipl.-Ing.
Donauhalde 22
W-7900 Ulm 1(DE)

(74) Vertreter: Schulze, Harald Rudolf, Dipl.-Ing.
TELEFUNKEN SYSTEMTECHNIK GMBH
Sedanstrasse 10
W-7900 Ulm(DE)

(54) Blitz- und Überspannungsschutzeinrichtung für geschirmte Kabel als Gebäude-Schutzeinrichtung.

(57) 2.1 Der Erfindung liegt die Aufgabe zugrunde, eine Blitz-und Überspannungsschutzeinrichtung für geschirmte Kabel zu schaffen, mit der innerhalb von ungeschirmten Räumen auf der Kabelschirmung Überspannungspegel von Blitzeinschlägen oder EMP-Ereignissen auf tolerierbare Grenzwerte gesenkt werden.

2.2 Diese Aufgabe wird dadurch gelöst, daß auf der äußeren und inneren Seite der Raumgrenze (10) im Bereich der Einführungstelle des Kabels (1) je ein Erdundssystem an die Kabelschirmung (2) angeschlossen ist, daß die Erdungssysteme aus einer rundumkontaktierenden Kabeldurchführung (5,13), einem großflächigem Ableitblech (4,12) und aus einem Erdungsleiter (7,14) bestehen, daß das Kabel (1) zwischen dem äußeren (4) und innerem Ableitblech (12) eine Gegeninduktivität aufweist, die aus der Leitungsinduktivität (11) der Kabelschirmung (2) und mindestens einer ferromagnetischen Ummantelung (21) besteht und daß die Ummantelung (21) gegenüber dem äußeren Ableitblech (4) elektrisch isloliert und mit dem inneren Ableitblech (12) elektrisch kurzgeschlossen ist.

2.3 Die Erfindung findet Anwendung bei Blitz- und Überspannungseinrichtungen für geschirmte Kabel, die in ungeschirmte Räume eingeführt sind und deren Kabelschirmung an der Einführungsstelle mit einem angeschlossenen Erdungsleiter geerdet ist.

Fig. 1

## BLITZ- UND ÜBERSPANNUNGSSCHUTZEINRICHTUNG FÜR GESCHIRMTE KABEL ALS GEBÄUDE-SCHUTZEINRICHTUNG

Die Erfindung betrifft eine Blitz- und Überspannungsschutzeinrichtung für geschirmte Kabel gemäß dem Oberbegriff des Anspruchs 1.

Gemäß den VDE-Vorschriften 0185, 0845 und 0855 ausgeführte Schutzmaßnahmen zur Sicherung von Empfangsanlagen in ungeschirmten Gebäuden, die sich auf die Erdung von Antennenmasten und der in das Gebäude eingeführten Empfangskabel beziehen, führen bei Blitzeinschlag ober bei EMP-Ereignissen nur einen Teil der eintreffenden Energie über die Erdungsleitung ab. Ein ebenso großer Energieanteil fließt über die Schirmung des Empfangskabels, das Empfangsgerät, und den geerdeten Netzanschluß des Empfangsgerätes ab. So kann es trotz einer Feinschutzeinrichtung an der Empfangsanlage, welche die Anlage gegen Störstromamplituden bis zu 10kA schützen kann (siehe z. B. das Prospektblatt "Computer leben gefährlich - Safety Board schützt!" der Firma Knürr AG), zu Schäden an der Anlage, der Feinschutzeinrichtung oder dem Empfangskabel kommen.

In der Vorschrift VG 96 907, Teil 1, für Verteidigungsgeräte sind Einführungsplatten oder -bleche mit rundumkontaktierenden Kabeldurchführungen beschrieben. Diese Kabeldurchführungen finden bei der Schirmung von Räumen Verwendung, die vollständig gegen das Einwirken von externen elektromagnetischen Feldern geschützt sind.

Der Erfindung liegt die Aufgabe zugrunde, eine Blitz- und Überspannungsschutzeinrichtung für geschirmte Kabel zu schaffen, die in ungeschirmte Räume eingeführt sind, mit der erreicht wird, daß innerhalb der ungeschirmten Räume auf der Kabelschirmung Überspannungspegel von Blitzeinschlägen oder EMP-Ereignissen auf tolerierbare Grenzwerte gesenkt werden.

Diese Aufgabe wird erfindungsgemäß durch die im Kennzeichen des Anspruchs 1 angegebenen Merkmale gelöst

Über die Gestaltung der Erfindung kann ein wirksamer Schutz an der Raumgrenze auf preiswerte Weise hergestellt werden. An bisher vorhandenen Empfangsanlagen ist die erfindungsgemäße Schutzeinrichtung nachrüstbar. Diese Nachrüstung kann ebenfalls mit geringem Aufwand durchgeführt werden.

Weiterbildungen sind in den Unteransprüchen angegeben, die preiswerte Ausführungen für die ferromagnetische Ummantelung offenbaren und Lösungen für eine Erhöhung der Wirksamkeit der Gegeninduktivität angeben.

Anhand der Zeichnung wird ein Ausführungsbeispiel der Erfindung näher erläutert.

Fig. 1 zeigt ein Ersatzschaltbild der Schutzeinrichtung,

Fig. 2 zeigt das äußere Ableitblech,

Fig. 3 zeigt die Kabeleinführung,

Fig. 4a zeigt eine Gegeninduktivität mit einer Gegenstrom-Schleife,

Fig. 4b zeigt das Ersatzschaltbild dieser Gegeninduktivität,

Fig. 5a zeigt eine Gegeninduktivität mit einer Gegenstrom-Spule,

Fig. 5b zeigt das Einschaltbild dieser Gegeninduktivität,

Fig. 6a zeigt eine Gegeninduktivität mit einer Gegenstrom-Schleife aus einem NE-Metallrohr und

Fig. 6b zeigt das Ersatzschaltbild dieser Gegenstrom-Schleife.

In den Figuren wird als Ausführungsbeispiel die Einführung eines Antennenkabels durch das Dach eines Gebäudes dargestellt.

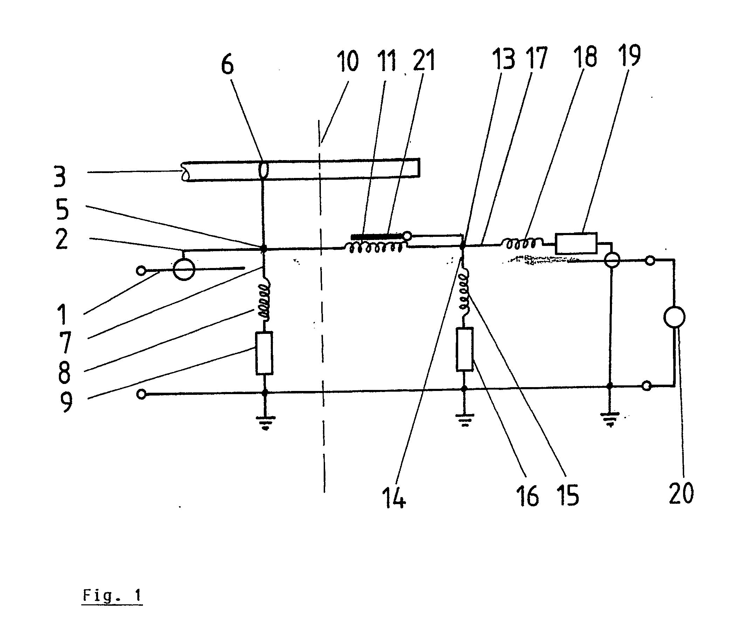

Fig. 1 zeigt das Ersatzschaltbild der Schutzeinrichtung mit einem - auf die Raumgrenze 10 bezogenen - äußeren und inneren Erdungssystem für die Kabelschirmung 2, einer zwischen den Anschlußpunkten der Erdungssysteme angeordneten Gegeninduktivität (11, 21) und einer Empfangsanlage 20.

Das äußere Erdungssystem ist im Ersatzschaltbild gekennzeichnet durch eine rundumkontaktierende Antennenmastdurchführung 6, einen Erdungsleiter 7 mit einer Leitungsinduktivität 8 und einem ohm'schen Leitungswiderstand 9 und den Anschluß des Erdungsleiters 7 an die Kabelschirmung 2 mit einer rundumkontaktierenden Kabeldurchführung 5, die in Fig. 1 als Knotenpunkt dargestellt ist.

Das innere Erdungssystem ist gekennzeichnet durch einen Erdungsleiter 14 mit einer Leitungsinduktivität 15 und einen ohm'schen Leitungswiderstand 16 und den Anschluß des Erdungsleiters 14 an die Kabelschirmung 2 mit einer rundumkontaktierenden Kabeldurchführung 13 (dargestellt als Knotenpunkt). Die Ableitbleche 4, 12 und die Anschlußleiter 23 der Ableitbleche 4, 12 sind in dem Ersatzschaltbild der Fig. 1 nicht dargestellt. Schaltungstechnisch weisen sie die Funktion eines elektrischen Leiters auf und sind damit durch die Erdungsleiter 7, 14 in Fig. 1 präsentiert. Für den Kabelschirmschnitt 17 zwischen dem Anschluß des inneren Erdungssystemes und der Empfangsanlage 20 ist eine Leitungsinduktivität 18 und ein ohm`scher Leitungswiderstand 19 in dem Ersatzschaltbild berücksichtigt. Das Ersatzschaltbild zeigt, daß der Leistungswiderstand zwischen dem äußeren und inneren Erdungssystem durch die Leitungsinduktivität 11 beeinflußt ist. Diese Induktivität 11 ist durch eine ferromagnetische Ummantelung 21 verstärkt und wirkt als Gegeninduktivität auf das Ableiten hochfrequenter Impulsanteile von Blitz-Einschlägen oder EMP-Impulsen ein. Das Ableiten dieser Impulsanteile auf das innere Kabelsystem wird durch diese Gegeninduktivität behindert. Zusätzlich wird durch das innere Erdungssystem die Empfangsanlage 20 vor Impulsanteilen geschützt, die durch die Gegeninduktivität hindurchgetreten sind.

Es gelten die Bedingungen:

$2\pi fL_{11} \gg (R_g + 2\pi fL_8)$

$2\pi fL_{11} \gg (R_{16} + 2\pi fL_{15})$

$(R_{19} + 2\pi fL_{18}) > (R_{16} + 2\pi fL_{15})$

($2\pi f \equiv$ Kreisfrequenz. Die Indexierung der ohm`schen Leitungswiderstände R und der Leitungsinduktivitäten L entspricht den Bezugszeichen der Fig. 1)

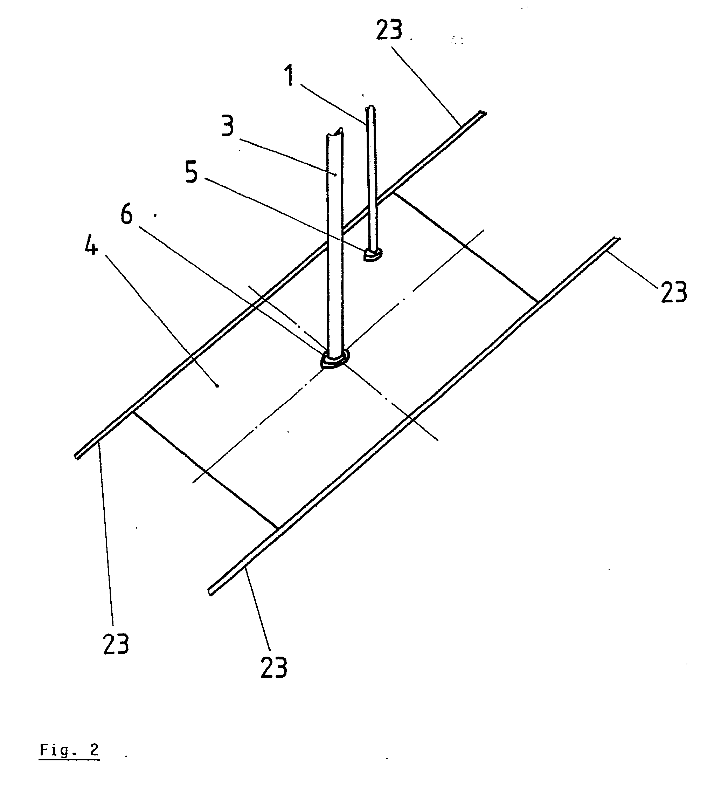

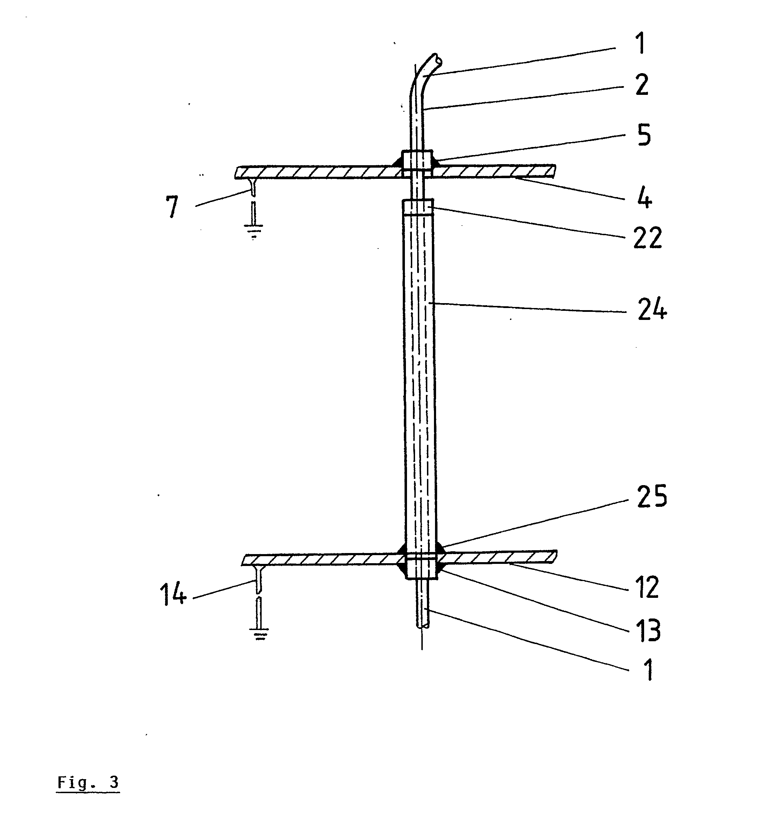

Fig. 2 zeigt die konstruktive Ausführung des äußeren Ableitbleches 4 der Schutzeinrichtung. Das Ableitblech 4 ist aus elektrisch leitfähigem Material gefertigt und seine Abmessungen betragen 2m x 1m. Die große Fläche des Ableitbleches verhindert wegen der hohen elektrischen Feldstärken an den Blechkanten ein mögliches Durchschlagen von Überspannungen auf das innere Kabelsystem. An den beiden Längskanten des Bleches 4 sind Anschlüsse 23 für den äußeren Erdungsleiter 7 angeschweißt. Das Ableitblech und die Anschlüsse können aus Aluminium, Kupfer oder ähnlichen elektrisch gutleitenden Materialien hergestellt werden und auch andere, als die obengenannte, Dimensionierungen aufweisen, die in bekanter Weise so ausgelegt sing, daß sie den Anforderungen für die Ableitung von Blitzeinschlägen oder Störimpulsen genügen. Die rundumkontaktierende Antennenmastdurchführung 6 und die rundumkontaktierende Kabeldurchführung 5 sind an geeigneter Stelle in das Ableitblech 4 eingesetzt. Das Kabel 1 kann auch durch ein Rohr geführt sein, wenn das Rohr auf der äußeren und inneren Fläche des Ableitbleches 4 rundumkontaktierend eingesetzt ist. Die Kabeleinführung der Schutzrichtung ist in Fig. 3 im Ausschnitt gezeigt. Als ferromagnetische Ummantelung 21 ist ein 1m langes Stahlrohr 24 mit einer Permeabilität von µ ungefähr 1000 über das Kabel 1 geschoben, das von einem Isolierring 22 gegenüber dem Ableitblech 4 elektrisch isoliert ist. Das Ableitblech 4 und das innere Ableitblech 12 sind in geeigneter, hier nicht dargestellter, Weise in die Dachfläche des Gebäudes integiert. An die Ableitbleche 4, 12 sind wie vorher beschrieben, Erdungsleiter 7 und 14 über Anschlußleiter 23 angeschlossen.

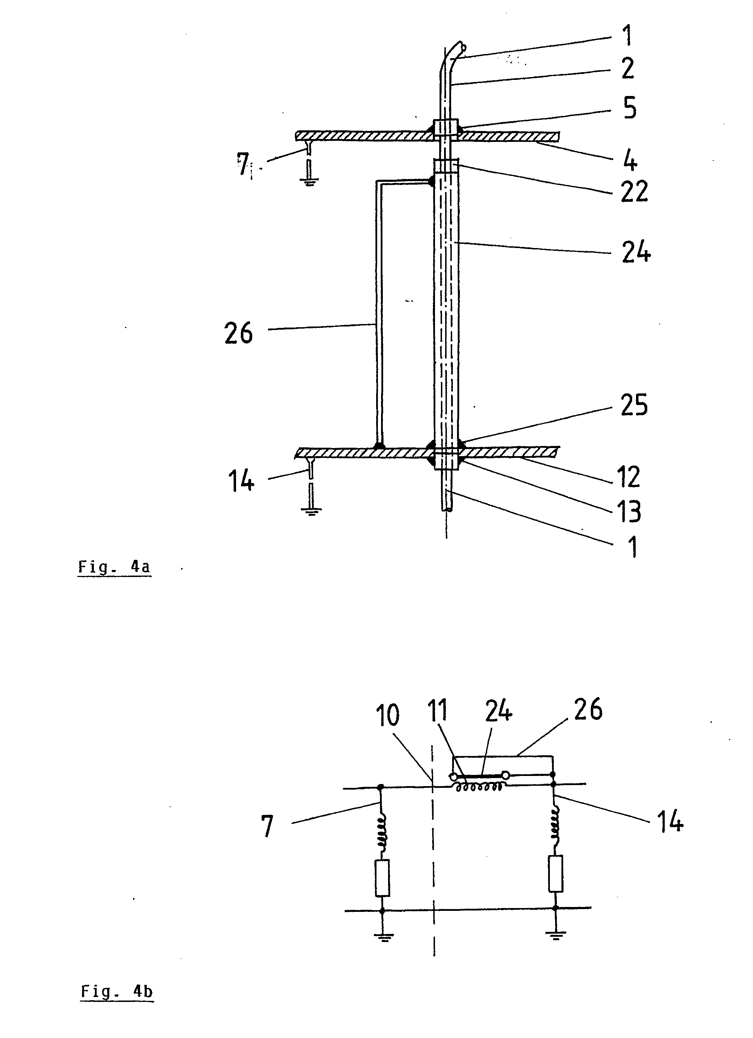

Die in Fig. 4a und in Fig. 4b gezeigte Kabeleinführung weist zusätzlich zu dem Stahlrohr 24 eine Gegenstrom-Schliefe 26 auf, durch die der Stromfluß eines in dem Stahlrohr 24 induzierten Gegenstromes verbessert und damit die Bremswirkung der Gegeninduktivität gesteigert ist.

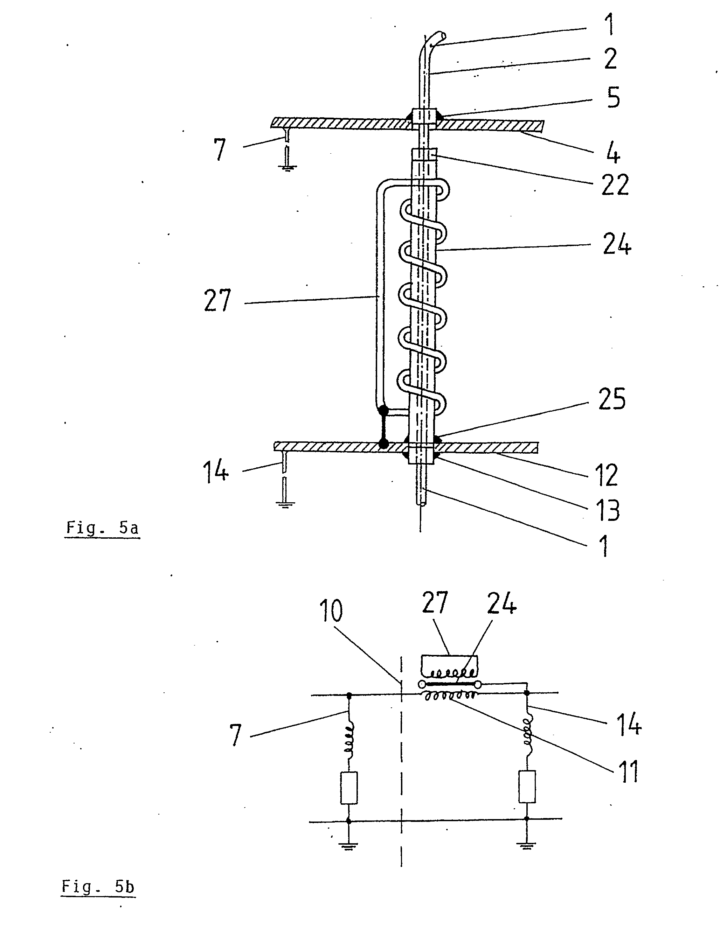

In Fig. 5a und in Fig. 5b ist eine Gegenstrom-Spule 27 gezeigt, die um das Stahlrohr 24 gewickelt und gegenüber der Stahlrohroberfläche elektrisch isoliert ist.

Die Gegenstrom-Spule 27 stellt eine weitere, wesent liche Steigerung der Wirkung der Gegeninduktivität dar. Insbesondere wird dadurch die Bremswirkung auf niederfrequente Impulsanteile ausgedehnt.

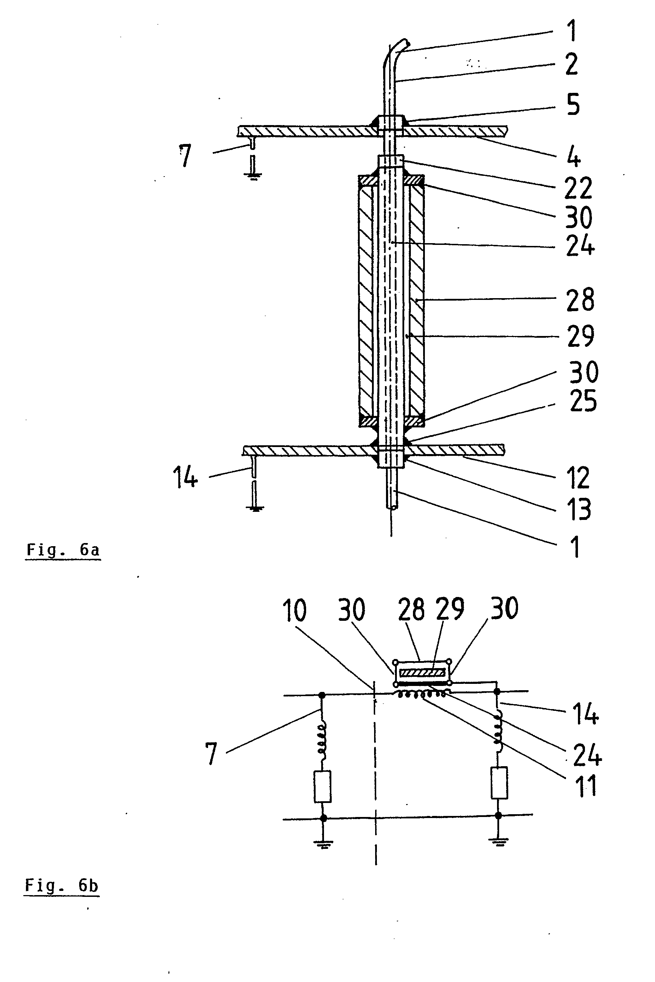

Die in Fig. 6a und in Fig. 6b dargestellte Gegenstrom-Schleife besteht aus einem Nichteisen-Metallrohr 28, das über das Stahlrohr 24 geschoben ist. Zwischen den beiden Rohren ist eine elektrisch isolierende Folie 29 angeordnet und die Enden des NE-Rohres 28 sind mit dem Stahlrohr 24 über Kurzschlußbrücken 30 elektrisch leitend verbunden, so daß ein geschlossener Stromkreis für den induzierten Gegenstrom entsteht.

## Ansprüche

1. Blitz- und Überspannungseinrichtung für geschirmte Kabel, die in ungeschirmte Räume eingeführt sind und deren Kabelschirmung an der Einführungsstelle mit einem angeschlossenen Erdungsleiter geerdet ist, dadurch gekennzeichnet, daß auf der äußeren und inneren Seite der Raumgrenze (10) im Bereich der Einführungsstelle des Kabels (1) je ein Erdungssystem an die Kabelschirmung (2) angeschlossen ist, daß die Erdungssysteme aus einer rundumkontaktierenden Kabeldurchführung (5,13), einem großflächigem Ableitblech (4,12) und aus einem Erdungsleiter (7,14) bestehen, daß das Kabel (1) zwischen dem äußeren (4) und innerem Ableitblech (12) eine Gegeninduktivität aufweist, die aus der Leitungsinduktivität (11) der Kabelschirmung (2) und mindestens einer ferromagnetischen Ummantelung (21) besteht und daß die Ummantelung (21) gegenüber dem äußeren Ableitblech (4) elektrisch isoliert und mit dem inneren Ableitblech (12) elektrisch kurzgeschlossen ist.

2. Schutzeinrichtung nach Anspruch 1, dadurch gekennzeichnet, daß die ferromagnetische Ummantelung (21) aus einem Stahlrohr (24) besteht, das mit einer Rundumkontaktierung (25) elektrisch leitend auf dem inneren Ableitblech (12) befestigt ist.

3. Schutzeinrichtung nach einen der Ansprüche 1 oder 2, dadurch gekennzeichnet, daß die Gegeninduktivität eine Gegenstrom-Schleife (26,28) enthält, die zusammen mit der ferromagnetischen Ummantelung (21) unter Kontaktierung des inneren Ableitbleches (12) einen geschlossenen Stromkreis für einen induzierten Gegenstrom bildet, der bei Impulsbelastung des Kabels (1) in diesem Stromkreis auftritt.

4. Schutzeinrichtung nach Anspruch 3, dadurch gekennzeichnet, daß die Gegenstrom-Schleife als Nichteisen-Metallrohr (28) ausgebildet ist, das über die ferromagnetische Ummantelung (21) geschoben und von dieser bis auf die Endbereiche durch eine elektrisch isolierende Folie (29) getrennt ist und das an seinen Enden über Kurzschlußbrücken (30) mit dem Stahlrohr (24) elektrisch leitend verbunden ist, so daß der geschlossene Stromkreis gebildet ist.

5. Schutzeinrichtung nach einen der Ansprüche 1 oder 2, dadurch gekennzeichnet, daß um die ferromagnetische Ummantelung (21) eine Gegenstrom-Spule (27) gewickelt ist, die im Wickelbereich von der Ummantelung (21) elektrisch isoliert und mit dem Ableitblech (12) elektrisch leitend verbunden ist.

6. Schutzeinrichtung nach einen der Ansprüche 1 bis 5, dadurch gekennzeichnet, daß die ferromagnetische Ummantelung (21) aus Ferritringen besteht, die über das Kabel (1) geschoben sind.

Fig. 1

Fig. 2

Fig. 3

Fig. 4a

Fig. 4b

Fig. 5a

Fig. 5b

Fig. 6a

Fig. 6b

# EUROPÄISCHER RECHERCHENBERICHT

**Europäisches Patentamt**

Nummer der Anmeldung

**EP 90 12 1369**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | ELEKTROTECHNISCHE ZEITSCHRIFT - ETZ. vol. 108, no. 13, Juli 1987, BERLIN DE Seiten 612 - 618; PETER HASSE: "Neues aus der Blitzachutztechnik" * Seiten 616 - 617 * | 1 | H 01 Q 1/50 H 02 G 13/00 |
| A | US-A-1 920 162 (E.V. AMY ET AL) * Seite 2, Zeilen 6 - 27; Figur 1 * | 1 | |
| A | US-A-4 267 529 (BRUN ET AL) | | |

|  |  |
|---|---|
|  | **RECHERCHIERTE SACHGEBIETE (Int. Cl.5)** |
|  | H 05 K H 01 H H 02 H |

Der vorliegende Recherchenbericht wurde für alle Patentansprüche erstellt

| Recherchenort | Abschlußdatum der Recherche | Prüfer |
|---|---|---|
| Den Haag | 01 März 91 | TOUSSAINT F.M.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument